# EUROPÄISCHE PATENTSCHRIFT

(11) **EP 3 927 549 B1**
(45) Veröffentlichungstag und Bekanntmachung des Hinweises auf die Patenterteilung: **03.01.2024**
(21) Anmeldenummer: 20700678.4
(22) Anmeldetag: 10.01.2020
(51) Int. Cl.: B29C 48/30, F02M 63/00, H10N 30/88

(54) **3D-DRUCK-INJEKTOR MIT KÜHLUNG**
3D-PRINTING INJECTOR HAVING COOLING MEANS
INJECTEUR D'IMPRESSION 3D À REFROIDISSEMENT

(30) Priorität: 19.02.2019 DE 102019202194
(43) Veröffentlichungstag der Anmeldung: 29.12.2021
(73) Patentinhaber: Robert Bosch GmbH, 70442 Stuttgart (DE)
(72) Erfinder: MAIER, Eberhard, 73257 Koengen (DE); SCHWEIZER, Benjamin, 72160 Horb (DE)
(86) Internationale Anmeldenummer: PCT/EP2020/050561
(87) Internationale Veröffentlichungsnummer: WO 2020/169261

(56) Entgegenhaltungen:
- CN-U- 206 912 251
- DE-A1-102013 204 105
- DE-A1-102017 204 509
- US-A- 4 553 059
- US-A1- 2015 221 854

## Beschreibung

Die vorliegende Erfindung betrifft einen 3D-Druck-Injektor mit einem elektrisch ansteuerbaren Aktor, sowie mit Mitteln zur Kühlung und damit zur Abfuhr der Wärme aus dem Aktor, gemäß Oberbegriff des Patentanspruches 1.

### Stand der Technik

Für die Herstellung dreidimensionaler Körper sind verschiedene 3D Drucktechniken bekannt, bei denen Pulver- oder Drahtmaterial lokal aufgeschmolzen wird, und man anschließend erstarren lässt. Innerhalb der Gruppe solcher Maschinen sind auch bereits Verfahren bekannt, bei welchen 3D Strukturen direkt aus der Schmelze heraus erzeugt werden. Die Realisierung erfolgt über das sogenannte DoD (Drop-on-Demand) -Prinzip. Dabei werden einzelne Tröpfchen aus z.B. einem Tiegel mit einem Aktor herausgelöst. Der Aktor kann dabei auf dem Magnetprinzip, auf dem Piezoprinzip, oder auf dem pneumatischen Antriebsprinzip basierend betätigt werden.

Ebenso ist die Anwendung des Massenträgheitsprinzips ebenso bekannt. Vielfach taucht auch ein Stempel in einen Kompressionsraum ein, um durch den sich ergebenden Überdruck einzelne Tröpfchen zu erzeugen. Die Tröpfchen werden hierbei durch den Überdruck im Kompressionsraum und trotz der hohen Oberflächenspannung von flüssigem Metall durch eine enge Düse gedrückt.

Im Fall der Verwendung eines Piezo-Sticks muss wie bei einer Verwendung in z.B. der Kfz-Einspritz-Injektor-Technik auf einen geeigneten Einbau geachtet werden. Zusätzlich zu der Bedingung, dass eine Piezo-Keramik in keinem Betriebsfall Zugspannungen aufnehmen kann, muss noch auf die Betriebstemperatur geachtet werden. Diese darf je nach Ladung/Betriebsspannung max. 150°C betragen

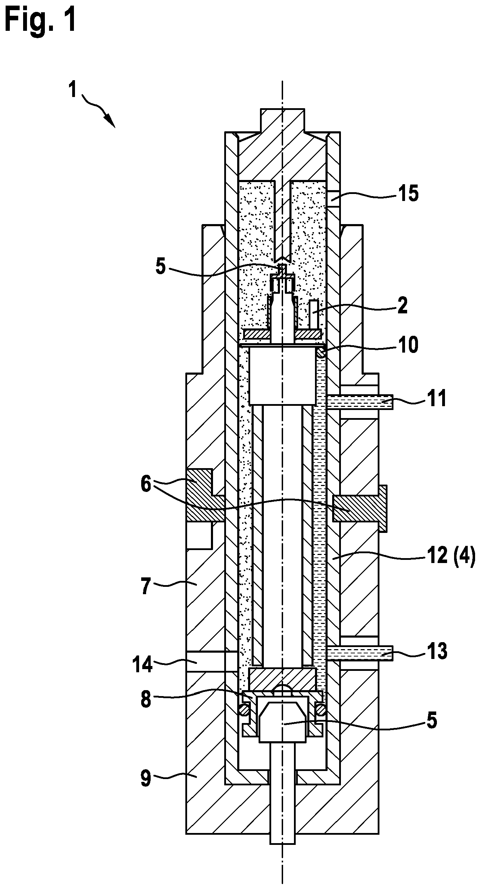

Aus der Publikation Jun Luo, Lehua Qi et al, International Journal of Machine Tools Manufacture 106 (2016) Abb. 1, ist eine solches, vorstehend genanntes System bekannt. Dort findet ebenfalls eine Wärmeabfuhr statt, die jedoch nicht effektiv genug ist, in Bezug auf die Abführung der Wärme von dort, wo der hoch beaufschlagte Aktor die meiste Wärme erzeugt.

Die Offenlegungsschrift DE 10 2017 204509 A1 zeigt einen Druckkopf für einen 3D-Drucker mit einem Piezoaktor als Antriebsquelle für die Bewegung eines Stempels, wobei der Piezoaktor in einer Hülse untergebracht ist und die Hülse einen von einem Kühlmittel durchströmbaren Hohlraum aufweist, wobei dieser den Piezoaktor kühlt.

Die Schrift CN 206 912 251 offenbart einen Metalldrucker, wobei der Druckprozess durch einen Piezokeramischen Stack angesteuert wird.

Sowohl das Dokument US 4 553 059 A als auch das Dokument US 2015/221854 A1 offenbaren Piezoaktoren, die über Kühlmittel gekühlt werden.

### Offenbarung der Erfindung

Im Rahmen der Erfindung wurde ein 3D-Druck-Injektor mit einem elektrisch ansteuerbaren Aktor, sowie mit Mitteln zur Kühlung und damit zur Abfuhr der Wärme aus dem Aktor konzipiert. Als Aktor ist ein piezoelektrischer Aktor mit piezoelektrischem Element vorgesehen, welcher unmittelbar von einem mit einem Kühlmedium durchströmbaren zylindrischen Kühlmittelmantel umgeben ist, in welchem der piezoelektrische Aktor auch geführt ist.

Die Erfinder haben erkannt, dass beim Betrieb im Druckkopf ein Lastkollektiv zu beachten ist. Dieses wird durch die geforderte Lebenszeit, den geforderten Hub, die geforderte Lastwechselzahl und auch die Temperatur begrenzt.

Da der Druckkopf mit Frequenzen, vorzugsweise von 1000 Hz betrieben wird, muss hierbei ein sorgfältiges Thermomanagement beachtet werden.

Im eindrucksvollen Vergleich zu einem 4-Zylinder Antriebsaggregat eines Kraftfahrzeuges, welches bei 4000rpm und 5 Einspritzungen pro Zyklus betrieben wird, tritt am Injektor gerade einmal eine Beaufschlagung von 40 Hz auf. Demgegenüber liegt die Beaufschlagungsfrequenz bei einem Druckkopf um den Faktor 25 höher.

Dies macht deutlich, dass im Sinne einer Begrenzung auf eine maximale Betriebstemperatur von bspw. 150°C im Piezo-Stick des Aktors hier technische Maßnahmen zu ergreifen sind, die die entscheidend größere Verlustleistung optimal abführen.

Dies geschieht mit den oben genannten Mitteln, bei denen der als piezoelektrischer Aktor ausgestalteter Aktor, unmittelbar von einem mit einem Kühlmedium durchströmbaren zylindrischen Kühlmittelmantel umgeben ist, in welchem der piezoelektrische Aktor auch geführt ist.

Es ist vorgesehen, dass der Aktor sich in Bewegungsrichtung axial erstreckt, und dass zumindest über die axiale Länge des piezoelektrischen Elementes sich der Kühlmittelmantel erstreckt.

Das Kühlmedium kann entweder flüssiges oder gasförmiges Kühlmedium sein. In beiden Fällen bewirkt die erfindungsgemäße konstruktive Ausgestaltung, dass das strömende Kühlmedium direkt am Ort der Wärmeerzeugung, nämlich am piezoelektrischen Element des Aktors einwirkt.

Ferner ist angegeben, dass der Kühlmittelmantel von einer weiteren Führungshülse umgeben ist. Dies vermittelt die Möglichkeit, dort die Ein- und Austrittstutzen des Kühlmantels mechanisch sicher fixieren zu können.

Der axial erstreckte piezoelektrische Aktor ist an beiden Enden zentrisch und kardanisch eingespannt.

Die beidseitige Einspannung an beiden Enden des Aktors erfolgt zentrisch und kardanisch. Damit wird erzielt, dass die Wärmeleitung, die im Piezoelement des Aktors entstehende Verlustleistung über die Führungshülse auf den Kühlflansch übertragen werden kann.

Ferner ist angegeben, dass der Kühlmitteleintritt im Aktor unten platziert ist. Dies gilt unabhängig davon, ob gasförmiges oder flüssiges Kühlmedium verwendet wird.

Erfindungsgemäß ist im Fall einer Kühlung mit einem gasförmigen Medium der Austrittstutzen des nach Kühlung erwärmten Mediums oberhalb der oberen zentrischen kardanischen Abstützung platziert. Hierbei wird der physikalischen Tatsache Rechnung getragen, dass für das gasförmige Kühlmedium mit kleinerer spezifischer Wärmekapazität als beim flüssigen Kühlmedium, ein größeres Volumen zur Verfügung steht.

Ferner ist erfindungsgemäß im Fall einer Kühlung mit einem flüssigen Medium der Austrittsstutzen des nach Kühlung erwärmten Mediums zwischen dem oberen Ende des piezoelektrischen Elementes des Aktors und der der oberen zentrischen kardanischen Abstützung platziert.

Dies ist eine effektive Kühlstrecke, für das Kühlmedium mit höherer spezifischer Wärmekapazität.

In einer vorteilhafter Ausgestaltung ist angegeben, dass ein über das piezoelektrische Element des Aktors nach unten mechanisch angetriebener Kolbenhut radial spielbehaftet in der Führungshülse platziert ist.

Auf diese Weise sind temperaturbedingte Verklemmungen in der Antriebsstrecke des Injektors beseitigt.

Weitere, die Erfindung verbessernde Maßnahmen werden nachstehend gemeinsam mit der Beschreibung der bevorzugten Ausführungsform der Erfindung anhand einer Figur näher dargestellt.

### Ausführungsbeispiel

Es zeigt:
- Figur 1: Querschnitt durch einen erfindungsgemäßen Aktor mit Darstellung zweier Kühlvarianten in einer gemeinsamen Darstellung.

Figur 1 zeigt einen Querschnitt durch den erfindungsgemäßen 3D-Druck Injektor 1 mit Kühlung. Der piezoelektrische Aktor ist innerhalb eines mediengekühlten, längs-, d.h. axial erstreckten Kühlflansches 7 angeordnet. Der Aktor ist an beiden Enden mit einer zentrischen kardanischen Einspannung 5 versehen, oben als zentrisch kardanische Abstützung und unten als zentrisch kardanische Kraftübertragung auf eine Kolbenstange. Mit in axialer Richtung mittig platzierten Führungs-/Arretierungselementen wird der Aktor im Kühlflansch gehalten.

Diese Darstellung zeigt die zwei erfindungsgemäßen Kühlungen innerhalb einer Darstellung. Bei einer ersten Alternative, mit Bezug auf eine Kühlung mit einem gasförmigen Medium, ist die Kühlgaseinleitung 14 links unten im Kühlflansch 7 vorgesehen. Der Austritt des erwärmten gasförmigen Kühlmediums erfolgt oben durch die Austrittsöffnung 15. Nach unten liegt der Aktor an einem frei beweglichen, vorzugsweise radial spielbehafteten Kolbenhut 8 an. Nach unten, d.h. unterhalb des Kolbens ist eine Abdichtung vorgesehen, vorzugsweise aus PTFE.

Der alternative Einsatz von flüssigem Kühlmedium ist auf der rechten Seite unten der Eintrittsstutzen 13 des kalten flüssigen Kühlmediums in die Führungshülse eingeschraubt.

Ferner ist dargestellt, dass der Aktor nochmals in einer Führungshülse 12 angeordnet ist, innerhalb der die Kühlung implementiert ist.

Für den Austritt des erwärmten flüssigen Kühlmediums ist eine Austrittsöffnung 11 in der Führungshülse 12 angeordnet. Kühlmittelmantel 4 und Führungshülse 12 haben hier erfindungsgemäß die besagte Doppelfunktion.

Für den flüssigen Kühlmittelraum erfolgt eine Abdichtung mit einem O-Ring 10.

Die Kühlmedienstrecke für das flüssige Kühlmedium mündet in axialer Entfernung zur Eintrittsöffnung auffallend kürzer beabstandet aus, als bei der gasförmigen Kühlung, was mit der höheren spezifischen Wärmekapazität des flüssigen Mediums gegenüber dem gasförmigen Medium zu tun hat.

Nachfolgend nochmals die Funktionsweise von Gaskühlung und Flüssigkühlung.

### Zur Gaskühlung:

Es wird wie beschrieben im unteren Bereich des Aktors beispielsweise kühle Druckluft zugeführt. Dieses Medium strömt über einen im Kühlflansch eingeschraubten Anschlussstutzen, über eine nachfolgende einfache Bohrung in der Führungshülse in den Spalt zwischen Führungshülse und Aktormodul und kann, erwärmt durch die Verlustleistung des Aktors im oberen Bereich wieder austreten. In diesem Fall wird kein O-Ring im oberen Bereich benötigt. Nach unten hin begrenzt eine PTFE-Führungshülse den Luftstrom. Daraus folgt, es bleibt nur der Weg nach oben. Undichtigkeiten über das Arretierungs- und Führungselement sind hier unproblematisch.

### Zur Flüssigkühlung:

Es wird im unteren Bereich eine Kühlflüssigkeit über einen in die Führungshülse eingeschraubten Anschlussstutzen in den Bereich zwischen Führungshülse und Aktormodul zugeführt. Die Flüssigkeit strömt in diesem Spalt nach oben. Im oberen Bereich wird diese unter dem eingebauten O-Ring wieder ausgeführt.

Durch den O-Ring wird die oben angeordnete elektrische Kontaktierung geschützt. Nach unten zur Kolbenstange ist ein im Kolbenhut eingebauter O-Ring die Abdichtung.

Da sich die Führungshülse in dem Kühlflansch verschieben kann, müssen sich in dem Kühlflansch Langloch Aussparungen für die in der Führungshülse eingeschraubten Stutzen befinden.

Insgesamt ist die Kühlung in beiden Varianten in hohem Maße effektiv.

## Patentansprüche

1. 3D-Druck-Injektor (1) mit einem elektrisch ansteuerbaren Aktor (2), sowie mit Mitteln zur Kühlung und damit zur Abfuhr der Wärme aus dem Aktor, wobei als Aktor (2) ein piezoelektrischer Aktor mit piezoelektrischem Element vorgesehen ist, der unmittelbar von einem mit einem Kühlmedium durchströmbaren zylindrischen Kühlmittelmantel (4) umgeben ist, in welchem der piezoelektrische Aktor (2) auch geführt ist, wobei der Aktor sich in Bewegungsrichtung axial erstreckt, und dass zumindest über die axiale Länge des piezoelektrischen Elementes sich der Kühlmittelmantel erstreckt, wobei der Kühlmittelmantel von einer weiteren Führungshülse (12) umgeben ist, wobei der axial erstreckte piezoelektrische Aktor an beiden Enden mit zentrisch angeordneten und in kardanischen Spann- oder Abstützelementen (5) eingespannt ist, wobei der Kühlmitteleintritt im Aktor unten platziert ist,
**dadurch gekennzeichnet, dass** im Fall einer Kühlung mit einem gasförmigen Medium der Austrittstutzen (15) des nach Kühlung erwärmten Mediums oberhalb der oberen zentrischen kardanischen Abstützung platziert ist, oder
dass im Fall einer Kühlung mit einem flüssigen Medium der Austrittsstutzen (11) des nach Kühlung erwärmten Mediums zwischen dem oberen Ende des piezoelektrischen Elementes des Aktors und der oberen zentrischen kardanischen Abstützung (5) platziert ist.

2. 3D-Druck-Injektor nach Anspruch 1, **dadurch gekennzeichnet, dass** ein über das piezoelektrische Element des Aktors nach unten mechanisch angetriebener Kolbenhut (8) radial spielbehaftet in der Führungshülse (12) platziert ist.

## Claims

1. 3D printing injector (1) having an electrically controllable actuator (2), and having means for cooling and thus for dissipating the heat from the actuator, wherein as actuator (2) a piezoelectric actuator with piezoelectric element is provided, which is directly surrounded by a cylindrical coolant jacket (4) that can be flowed through by a cooling medium, in which the piezoelectric actuator (2) is also guided, wherein the actuator extends axially in the movement direction, and that the actuator extends axially in the movement direction, and in that the coolant jacket extends at least over the axial length of the piezoelectric element, wherein the coolant jacket is surrounded by a further guide sleeve (12), wherein the axially extended piezoelectric actuator is clamped at both ends in centrically arranged cardanic clamping or support elements (5), wherein the coolant inlet in the actuator is placed at the bottom, **characterized in that** in the case of a cooling with a gaseous medium the outlet connector (15) of the medium heated after the cooling is placed above the upper centric cardanic support, or **in that** in the case of a cooling with a liquid medium the outlet connector (11) of the medium heated after the cooling is placed between the upper end of the piezoelectric element of the actuator and the upper centric cardanic support (5).

2. 3D printing injector according to Claim 1, **characterized in that** a piston hat (8) mechanically driven downwards via the piezoelectric element of the actuator is placed in the guide sleeve (12) with radial play.

## Revendications

1. Injecteur d'impression 3D (1) comprenant un actionneur (2) commandable électriquement ainsi que des moyens de refroidissement et donc de dissipation de la chaleur de l'actionneur, l'actionneur (2) étant un actionneur piézoélectrique pourvu d'un élément piézoélectrique qui est immédiatement entouré d'une enveloppe d'agent de refroidissement cylindrique (4) à travers laquelle peut circuler un milieu de refroidissement et dans laquelle l'actionneur piézoélectrique (2) est également guidé, l'actionneur s'étendant axialement dans la direction de mouvement et l'enveloppe d'agent de refroidissement s'étendant au moins sur la longueur axiale de l'élément piézoélectrique, l'enveloppe d'agent de refroidissement étant entourée d'un autre manchon de guidage (12), l'actionneur piézoélectrique qui s'étend axialement étant serré aux deux extrémités avec des éléments de serrage ou de support (5) disposés centralement et à cardan, l'entrée d'agent de refroidissement dans l'actionneur étant placée en bas,
**caractérisé en ce que**, dans le cas d'un refroidissement avec un milieu gazeux, le raccord de sortie (15) du milieu chauffé après refroidissement est placé au-dessus du support de cardan central supérieur, ou
**en ce que**, dans le cas d'un refroidissement avec un milieu liquide, le raccord de sortie (11) du milieu chauffé après refroidissement est placé entre l'extrémité supérieure de l'élément piézoélectrique de l'actionneur et le support de cardan central supérieur (5) .

2. Injecteur d'impression 3D selon la revendication 1, **caractérisé en ce qu'**un capuchon de piston (8), qui est entraîné mécaniquement vers le bas par l'élément piézoélectrique de l'actionneur, est placé dans le manchon de guidage (12) avec jeu radial.
